(19) **Europäisches Patentamt European Patent Office Office européen des brevets**

(11) **EP 2 737 305 B1**

(12) **FASCICULE DE BREVET EUROPEEN**

(45) Date de publication et mention de la délivrance du brevet:
**30.09.2015 Bulletin 2015/40**

(51) Int Cl.:
**G01N 27/04** *(2006.01)*    **C30B 29/06** *(2006.01)*

(21) Numéro de dépôt: **12748738.7**

(86) Numéro de dépôt international:
**PCT/FR2012/000299**

(22) Date de dépôt: **20.07.2012**

(87) Numéro de publication internationale:
**WO 2013/014342 (31.01.2013 Gazette 2013/05)**

(54) **DÉTERMINATION DES TENEURS EN DOPANTS DANS UN ÉCHANTILLON DE SILICIUM COMPENSÉ**

BESTIMMUNG DES DOTIERSTOFFGEHALTS EINER KOMPENSIERTEN SILIZIUMPROBE

DETERMINING THE DOPANT CONTENT OF A COMPENSATED SILICON SAMPLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.07.2011 FR 1102354**

(43) Date de publication de la demande:
**04.06.2014 Bulletin 2014/23**

(73) Titulaire: **Commissariat à l'Énergie Atomique et aux Énergies Alternatives 75015 Paris (FR)**

(72) Inventeurs:
• **DUBOIS, Sébastien**
  **74950 Scionzier (FR)**
• **ENJALBERT, Nicolas**
  **81100 Burlats (FR)**
• **VEIRMAN, Jordi**
  **74330 Poisy (FR)**

(74) Mandataire: **Talbot, Alexandre et al Cabinet Hecké Europole 10, rue d'Arménie - BP 1537 38025 Grenoble Cedex 1 (FR)**

(56) Documents cités:
**WO-A2-2008/112598    CA-A1- 2 673 621**

• **BIANCA LIM ET AL: "Carrier mobilities in multicrystalline silicon wafers made from UMG-Si", PHYSICA STATUS SOLIDI (C), vol. 8, no. 3, 23 novembre 2010 (2010-11-23), pages 835-838, XP055021635, ISSN: 1862-6351, DOI: 10.1002/pssc.201000144**
• **A.J.R. DE KOCK ET AL: "The effect of doping on the formation of swirl defects in dislocation-free czochralski-grown silicon crystals", JOURNAL OF CRYSTAL GROWTH, vol. 49, no. 4, 1 août 1980 (1980-08-01), pages 718-734, XP024450445, ISSN: 0022-0248, DOI: 10.1016/0022-0248(80)90299-7**
• **MACDONALD D ET AL: "Measuring dopant concentrations in compensated p-type crystalline silicon via iron-acceptor pairing", APPLIED PHYSICS LETTERS, AIP, vol. 92, no. 20, 23 mai 2008 (2008-05-23), pages 202119-202119, XP012107145, AMERICAN INSTITUTE OF PHYSICS, MELVILLE, NY, US ISSN: 0003-6951, DOI: 10.1063/1.2936840**
• **CHARLES BABER ET AL: "Net and total shallow impurity analysis of silicon by low temperature fourier transform infrared spectroscopy", THIN SOLID FILMS, ELSEVIER-SEQUOIA S.A. LAUSANNE, CH, vol. 72, no. 1, 15 septembre 1980 (1980-09-15), pages 201-210, XP025719592, ISSN: 0040-6090, DOI: 10.1016/0040-6090(80)90575-1 [extrait le 1980-09-15]**
• **MARGARET WRIGHT JENKINS: "A new preferential etch for defects in silicon crystals", JOURNAL OF THE ELECTROCHEMICAL SOCIETY, vol. 124, no. 5, 31 mai 1977 (1977-05-31), pages 757-762, XP002671324, DOI: 10.1149/1.2133401**

EP 2 737 305 B1

- VEIRMAN J ET AL: "Electronic properties of highly-doped and compensated solar-grade silicon wafers and solar cells", JOURNAL OF APPLIED PHYSICS, vol. 109, no. 10, 24 mai 2011 (2011-05-24), pages 103711-103711, XP012146886, AMERICAN INSTITUTE OF PHYSICS. NEW YORK, US ISSN: 0021-8979, DOI: 10.1063/1.3585800

## Description

### Domaine technique de l'invention

L'invention est relative à la détermination des teneurs en dopants dans un échantillon de silicium, et plus particulièrement dans un lingot destiné à l'industrie photovoltaïque.

### État de la technique

Le silicium métallurgique purifié (« Upgraded Metallurgical Grade Silicon » en anglais, UMG-Si) est généralement compensé en impuretés dopantes. Le silicium est dit compensé lorsqu'il contient les deux types d'impuretés dopantes : accepteur et donneur d'électrons.

En fonction des concentrations en dopants accepteurs $N_A$ et donneurs $N_D$, on peut définir plusieurs niveaux de compensation, la compensation parfaite étant obtenue pour $N_A = N_D$. Typiquement, les impuretés de type accepteur sont des atomes de bore et les impuretés de type donneur sont des atomes de phosphore.

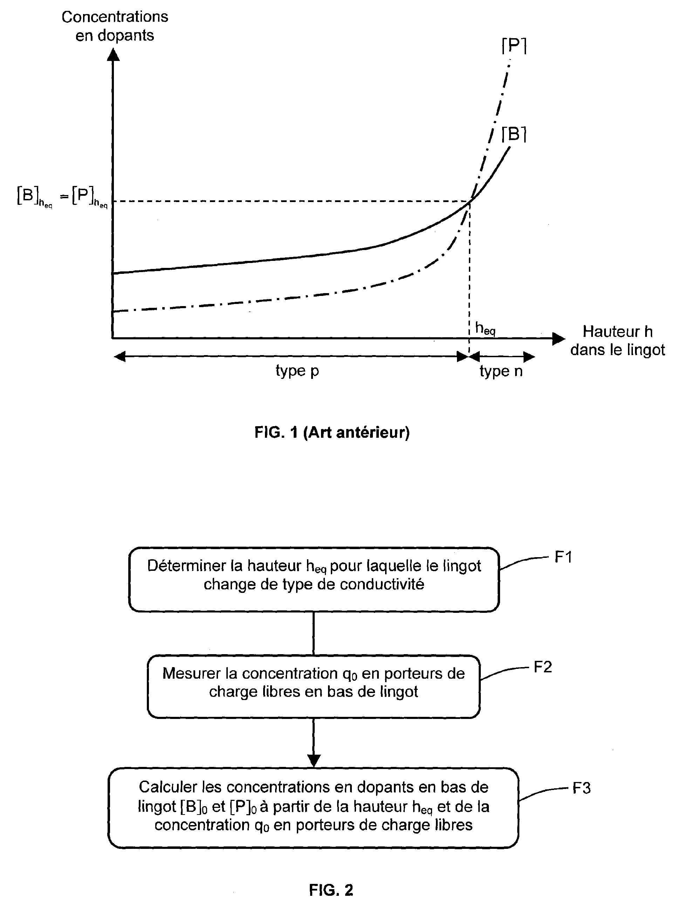

La figure 1 représente la concentration en bore [B] et la concentration en phosphore [P], en fonction de la position h dans un lingot de silicium de qualité métallurgique.

Comme les deux types d'impuretés sont présents simultanément, le type de conductivité du silicium est déterminé par l'impureté ayant la plus grande concentration. Dans la partie basse du lingot (h faible), la concentration en atomes de bore est supérieure à la concentration en atomes de phosphore, le silicium est alors de type p. A l'inverse, dans la partie haute, la concentration en phosphore dépasse la concentration en bore. Le silicium est alors de type n.

Ainsi, le lingot présente, à une hauteur $h_{eq}$, un changement du type de conductivité, du type p vers le type n dans l'exemple de la figure 1. A cette hauteur, les concentrations en bore et en phosphore sont égales ($[B]_{h_{eq}} = [P]_{h_{eq}}$), ce qui signifie que le silicium est parfaitement compensé.

La fabrication de cellules photovoltaïques à partir de plaques en UMG-Si nécessite un contrôle rigoureux des teneurs en dopants. En effet, les concentrations en dopants accepteurs et donneurs influent sur les propriétés électriques des cellules, comme le rendement de conversion.

Il paraît donc important de connaître les concentrations en dopants au sein du lingot de silicium, notamment pour déterminer si des étapes additionnelles de purification sont nécessaires. Il est également utile de connaître les concentrations en dopants au sein de la charge de silicium utilisée pour fabriquer le lingot. Ces informations permettent ensuite d'optimiser les procédés de fabrication des cellules photovoltaïques.

La détermination des concentrations en dopants est généralement réalisée par le fournisseur du lingot de silicium, à l'issue de sa cristallisation. Diverses techniques peuvent être employées.

La demande de brevet CA2673621 décrit une méthode pour déterminer les concentrations en dopants dans un lingot de silicium compensé. La résistivité électrique est mesurée sur la hauteur du lingot pour détecter la transition entre une conductivité de type p et une conductivité de type n. En effet, cette transition se traduit par un pic de la résistivité. Les concentrations en bore et en phosphore à la jonction p-n sont ensuite calculées à partir de la valeur de résistivité à la jonction et d'une relation empirique. On peut alors en déduire les concentrations en dopants dans l'ensemble du lingot à l'aide de la loi de Scheil.

L'article « Segragation and crystallization of purified metallurgical grade silicon : Influence of process parameters on yield and solar cell efficiency » (B. Drevet et al., 25th European PV Solar Energy Conference and Exhibitation, Valencia, 2010) décrit une autre technique de détermination des concentrations en dopants. La hauteur $h_{eq}$ du changement de type de conductivité est d'abord déterminée. Puis, la résistivité électrique p est mesurée, comme dans le document CA2673621. Par contre, elle n'est pas mesurée à la transition p-n mais à l'extrémité basse du lingot, c'est-à-dire dans la zone correspondant au début de la solidification. Les paramètres $h_{eq}$ et p sont ensuite injectés dans une équation tirée de la loi de Scheil pour déterminer les profils de concentration dans le lingot.

Ces techniques, basées sur une mesure de résistivité, ne sont toutefois pas satisfaisantes. En effet, on observe des écarts importants entre les valeurs de concentration en dopants obtenues avec ces techniques et les valeurs attendues.

L'article "Carrier mobilities in multicrystalline silicon wafers made from UMG-Si", (Phys. Status Solidi C 8 2011 835-838) par Bianca Lim, Martin Wolf et Jan Schmidt, décrit également une méthode de déterminer les concentrations en dopants accepteurs et donneurs dans un lingot de silicium métellurgique (compensé).

### Résumé de l'invention

On constate qu'il existe un besoin de prévoir un procédé précis et facile à mettre en oeuvre pour déterminer des concentrations en impuretés dopantes dans un échantillon de silicium compensé.

On tend à satisfaire ce besoin à l'aide des étapes suivantes :

- prévoir un lingot de silicium comportant des impuretés dopantes de type donneur et des impuretés dopantes de type accepteur ;

- déterminer la position d'une première zone du lingot, dans laquelle s'effectue une transition entre un premier type de conductivité et un second type de conductivité opposé ;

- mesurer la concentration en porteurs de charge libres dans une seconde zone du lingot, distincte de la première zone, par effet Hall ou par spectroscopie infrarouge à transformée de Fourrier ; et

- déterminer les concentrations en impuretés dopantes dans l'échantillon à partir de la position de la première zone et de la concentration en porteurs de charge libres dans la seconde zone du lingot.

Dans un mode de réalisation préférentiel, la seconde zone est une extrémité du lingot représentative d'un début de solidification.

Selon un développement, la position de la première zone du lingot est obtenue en soumettant des portions du lingot à un traitement chimique à base d'acide fluorhydrique, d'acide nitrique, et d'acide acétique ou phosphorique, permettant de révéler des défauts sur l'une des portions correspondant à la transition entre le premier type de conductivité et le second type de conductivité, et en déterminant la position dans le lingot de la portion présentant les défauts.

Dans une variante de réalisation du procédé, le lingot de silicium comprend des atomes de bore et des atomes d'oxygène, et la concentration en porteurs de charge libres dans une seconde zone du lingot, de type p, est obtenue en suivant l'évolution sous éclairement de la durée de vie des porteurs de charge.

## Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1, précédemment décrite, représente des profils classiques de concentration en dopants le long d'un lingot de silicium compensé ;

- la figure 2 représente des étapes d'un procédé de détermination des concentrations en dopants dans le lingot, selon un mode de mise en oeuvre préférentiel de l'invention ;

- la figure 3 représente la résistivité électrique le long du lingot de silicium ;

- la figure 4 représente différentes plaques issues du lingot de silicium, après une étape de polissage chimique ; et

- la figure 5 représente la durée de vie sous éclairement des porteurs de charge dans le lingot, en fonction du temps d'exposition.

## Description d'un mode de réalisation préféré de l'invention

On propose ici un procédé de détermination des concentrations en impuretés dopantes dans un échantillon de silicium compensé, basé sur une mesure de la concentration q en porteurs de charges plutôt qu'une mesure de la résistivité. La concentration q est mesurée par effet Hall, par spectroscopie infrarouge à transformée de Fourrier (FTIR), par un relevé de caractéristiques C-V ou par une technique faisant intervenir la durée de vie sous éclairement des porteurs de charge. A partir de la concentration q et de la position $h_{eq}$ de la transition p-n dans le lingot (ou n-p le cas échéant), on peut calculer précisément les concentrations en dopants accepteurs et donneurs de l'échantillon.

Par définition, le lingot de silicium comprend des impuretés dopantes de type accepteur et de type donneur. Une impureté dopante peut être constituée par un atome seul ou par un agglomérat d'atomes (complexes), tels que les donneurs thermiques. Dans la description qui suit, on prendra l'exemple d'un atome de bore en tant qu'impureté de type accepteur et d'un atome de phosphore en tant qu'impureté de type donneur. D'autres dopants pourraient toutefois être envisagés, comme l'arsenic, le gallium, l'antimoine, l'indium...

Le lingot est, de préférence, tiré selon la méthode Czochralski. Par la suite, on appellera « bas du lingot » ou « pied du lingot » la zone correspondant au début de la solidification et la hauteur désignera la dimension du lingot suivant l'axe de solidification. En particulier, la hauteur $h_{eq}$ de la transition p-n sera calculée par rapport au bas du lingot et s'exprimera en pourcentage de sa hauteur totale (hauteur relative).

La figure 2 représente des étapes d'un mode de mise en oeuvre préférentiel du procédé de détermination.

Lors d'une première étape F1, on détermine la hauteur $h_{eq}$ du lingot pour laquelle on observe un changement du type de conductivité, par exemple du type p au type n (Fig.1). Plusieurs techniques permettant de détecter la transition p-n sont détaillées ci-après.

Une première technique consiste à mesurer la résistivité électrique à différentes hauteurs du lingot.

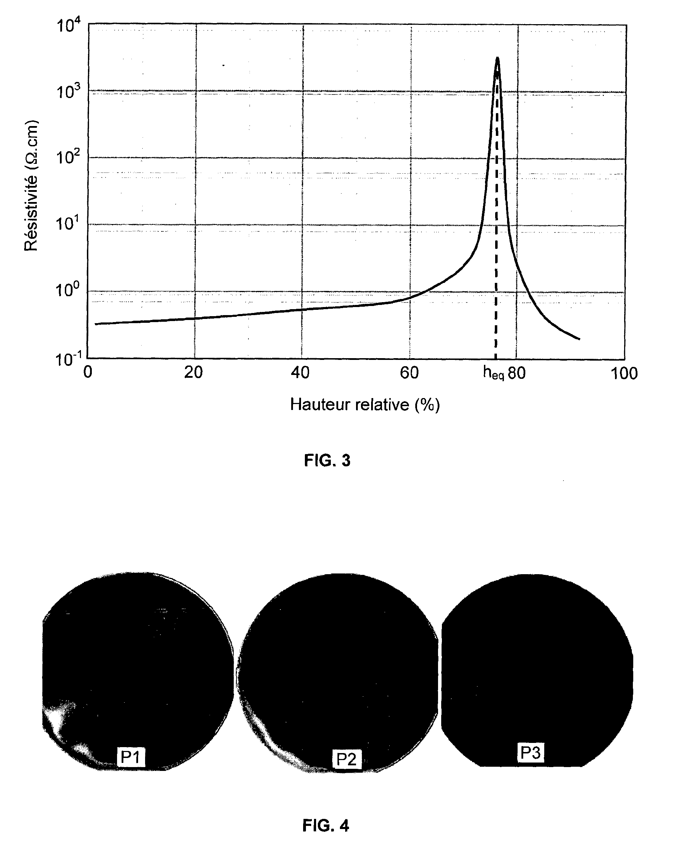

La figure 3 est un exemple de relevé de la résistivité électrique en fonction de la hauteur relative dans un lingot de silicium compensé. Un pic de la résistivité apparaît à environ 76 % de la hauteur totale du lingot.

Ce pic peut être attribué au changement du type de conductivité, obtenu lorsque le silicium est parfaitement compensé. En effet, au fur et à mesure que la concentration en phosphore [P] se rapproche de la concentration en bore [B] (Fig.1), le nombre de porteurs de charge libres tend vers zéro. Cela est dû au fait que les électrons fournis par les atomes de phosphore compensent les trous fournis par les atomes de bore. Alors, la résistivité augmente fortement. Une fois l'équilibre atteint, pour $[B]_{heq} = [P]_{heq}$, la résistivité diminue car le nombre de porteurs de charge (les électrons) augmente.

Ainsi, l'abscisse du pic de résistivité correspond à la position $h_{eq}$ dans le lingot du basculement du type de conductivité. Dans cet exemple, $h_{eq}$ vaut 76 %.

La mesure de résistivité peut être réalisée de façon simple par la méthode des quatre pointes ou par une méthode sans contact, par exemple par couplage inductif.

Une deuxième technique consiste à mesurer directement le type de conductivité sur la hauteur du lingot. La détermination du type de conductivité repose sur la méthode de mesure du potentiel de surface (SPV, « surface photo voltage » en anglais). Le principe d'une telle mesure est le suivant. Un laser est appliqué périodiquement sur la surface du lingot, ce qui va générer temporairement des paires d'électron-trou. Le couplage capacitif entre la surface du lingot et une sonde permet de déterminer le potentiel de surface.

La différence entre le potentiel de surface sous éclairement et le potentiel de surface sous obscurité, et plus particulièrement le signe de cette différence, permet de déterminer le type de conductivité dans la zone examinée du lingot. La mesure du type de conductivité par la méthode SPV est, par exemple, réalisée au moyen de l'équipement PN-100 commercialisé par la société SEMILAB.

Dans le cas du lingot de la figure 3, la mesure du type de conductivité indique un basculement du type p au type n à environ 76 % de la hauteur totale du lingot.

Un autre technique, basée sur un polissage chimique, peut être utilisée pour déterminer $h_{eq}$ dans un lingot de silicium monocristallin obtenu par la méthode Czochralski. Plusieurs portions du lingot sont plongées dans un bain contenant de l'acide acétique ($CH_3COOH$), de l'acide fluorhydrique (HF) et de l'acide nitrique ($HNO_3$). La durée du traitement varie en fonction de la température du bain. Elle est, de préférence, comprise entre 1 min et 10 min. A titre d'exemple, le bain chimique comprend trois volumes d'une solution d'acide acétique à 99 % et trois volumes d'une solution d'acide nitrique à 70 %, pour un volume d'acide fluorhydrique à 49 %. De l'acide phosphorique ($H_3PO_4$) peut aussi remplacer l'acide acétique.

Les inventeurs ont constaté, qu'à l'issue d'une telle étape, la portion la plus résistive du lingot, c'est-à-dire celle où s'effectue la transition p-n, présente des défauts cristallographiques en forme de cercles concentriques ou d'ellipses (appelés « swirls » en anglais). La position de cette zone dans le lingot correspond alors à la hauteur $h_{eq}$.

Avantageusement, le lingot est découpé en une pluralité de plaques, par exemple à la scie diamant, puis les plaques sont soumises au traitement chimique.

La figure 4 regroupe trois photographies de plaques ayant subi l'étape de polissage chimique. On constate que la plaque P2, au centre, présentent des défauts cristallographiques en surface. La plaque P2 est donc issue de la zone de transition du lingot. Les plaques P1 et P3 sont représentatives des zones du lingot situées respectivement avant et après le basculement du type de conductivité.

De préférence, le bain chimique est une solution aqueuse ne contenant que les trois acides susmentionnés. En d'autres termes, il est constitué d'eau, d'acide nitrique, d'acide fluorhydrique, et d'acide acétique ou phosphorique. Avec un bain dépourvu de toute autre espèce chimique, comme les métaux, on évite une contamination des plaques de silicium qui les rendrait inutilisables pour certaines applications (photovoltaïques notamment).

A l'étape F2 de la figure 2, on mesure la concentration en porteurs de charge $q_0$ dans une zone du lingot, distincte de la zone de transition. Dans ce mode de mise en oeuvre préférentiel, la mesure est réalisée au pied du lingot, ce qui simplifie le calcul ultérieur des concentrations en dopants (étape F3). Différentes techniques peuvent être employées.

La mesure par effet Hall, utilisée dans l'article « Electron and hole mobility reduction and Hall factor in phosphorus-compensated p-type silicon » (F.E. Rougieux et al., Journal of Applied Physics 108, 013706, 2010), permet de déterminer la concentration $q_0$ en porteurs de charge dans un échantillon de silicium compensé.

Cette technique requiert tout d'abord la préparation de l'échantillon en silicium. A titre d'exemple, une plaque de silicium d'environ 450 μm d'épaisseur est prélevée à l'extrémité basse du lingot. Puis, un barreau de 10x10 $mm^2$ de surface est découpé au laser dans la plaque. Quatre contacts électriques en InGa sont formés sur les côtés du barreau.

La mesure par effet Hall est, de préférence, réalisée à température ambiante. Elle permet d'obtenir la concentration en porteurs de Hall, $q_{0H}$, grâce à laquelle on peut calculer $q_0$ en utilisant la relation suivante :

$$q_0 = r_H \times q_{0_H}.$$

Le facteur de Hall $r_H$, tiré de l'article susmentionné, est environ égal à 0,71 dans le silicium compensé.

Dans le lingot correspondant à la figure 3, la valeur de $q_{0H}$ obtenue est de $1,5.10^{17}$ cm$^{-3}$ environ, soit une concentration en porteurs de charge $q_0$ en bas du lingot de l'ordre de $9,3.10^{16}$ cm$^{-3}$.

Alternativement, la concentration $q_0$ en porteurs de charge peut être mesurée par spectroscopie infrarouge à transformée de Fourrier (FTIR). La technique FTIR mesure l'absorption d'un rayonnement infrarouge dans le silicium, en fonction de la longueur d'onde $\lambda$, de ce rayonnement. Les impuretés dopantes, ainsi que les porteurs de charge, contribuent à cette absorption. Or, il a été montré dans l'article « Doping concentration and mobility in compensated material : comparison of different determination methods » (J. Geilker et al., 25th European PV Solar Energy Conference and Exhibition, Valencia, 2010) que l'absorption par les porteurs de charge varie selon une fonction de $\lambda^2$ et de $q_0^2$. Ainsi, en relevant l'absorption sur les spectres FTIR, on peut en déduire une valeur de $q_0$.

Contrairement à la mesure par effet Hall, la mesure FTIR est sans contact et peut être appliquée directement sur le lingot de silicium.

La concentration $q_0$ peut également être déterminée par la méthode de mesure C-V (« Capacitance-voltage »). Cette mesure nécessite la préparation d'un échantillon de silicium, prélevé en bas du lingot. Une grille, par exemple en métal, est déposée sur l'échantillon de manière à créer une capacité MOS. Puis, on mesure la capacité électrique en fonction de la tension appliquée sur la grille. Comme cela est décrit dans l'article « Determination of the base dopant concentration of large area crystalline silicon solar cells» (D. Hinken et al., 25th European PV Solar Energy Conference and Exhibition, Valencia, 2010), la dérivée de la capacité C(V) au carré est proportionnelle à $q_0$ :

$$\frac{\partial\left(\dfrac{1}{C^2}\right)}{\partial V} \propto q_0$$

En mesurant la pente de la courbe $1/C^2$ en fonction de V, on peut déterminer $q_0$.

Dans le cas d'un lingot dopé au bore et comprenant des atomes d'oxygène, on pourra envisager une dernière technique pour déterminer $q_0$, qui consiste à activer des complexes bore-oxygène en éclairant le bas du lingot. En effet, l'apport d'énergie, sous la forme de photons, modifie la configuration spatiale des complexes formés lors de la cristallisation.

La détermination de $q_0$ passe par un modèle décrivant la cinétique d'activation sous éclairement de ces complexes bore-oxygène. Le modèle est le suivant.

L'article « Kinetics of the electronically stimulated formation of a boron-oxygen complex in cristalline silicon » (D.W. Palmer et al., Physical Review B 76, 035210, 2007) montre que la concentration $N^*_{rel}$ des complexes bore-oxygène activés dans un silicium cristallin varie de façon exponentielle avec le temps t d'exposition à la lumière :

$$N^*_{rel}(t) = \exp(-R_{gen}t) \qquad (1).$$

$R_{gen}$ est la vitesse de génération de ces complexes, donnée par la relation suivante :

$$R_{gen} = \kappa_0 \cdot \exp(\frac{-E_a}{k_B T}) \qquad (2),$$

$E_A$ étant l'énergie d'activation ($E_A$ = 0,47 eV), $k_B$ la constante de Boltzmann et T la température du lingot (en Kelvin).

Dans un silicium dopé uniquement au bore, le terme $\kappa_0$ est proportionnel au carré de la concentration en atomes de bore ($\kappa_0 = A \cdot [B]_0^2$), d'après l'article de Palmer et al.

Par contre, dans le cas du silicium compensé, il faut remplacer la concentration en atomes de bore $[B]_0$ par le dopage net, c'est-à-dire la différence entre les concentrations en bore et en phosphore $[B]_0 - [P]_0$. Ce dopage net équivaut

à la concentration $q_0$ en porteurs de charge.

On peut alors en déduire une relation entre la vitesse de génération $R_{gen}$ des complexes bore-oxygène et la concentration $q_0$ en porteurs de charge :

$$R_{gen} = A \cdot q_0^2 \cdot \exp(\frac{-E_a}{k_B T}) \qquad (3)$$

A est une constante valant $5,03.10^{-29}$ $s^{-1}.cm^6$.

Ainsi, pour déterminer $q_0$, on mesure la concentration $N_{rel}^*$ des complexes bore-oxygène à un instant donné puis on utilise les relations (1) et (2).

La concentration $N_{rel}^*$ peut être obtenue en mesurant la variation de la durée de vie $\tau$ des porteurs de charge au cours du temps. En effet, $N_{rel}^*$ et sont liés par les relations suivantes :

$$N_{rel}^*(t) = \frac{N^*(\infty) - N^*(t)}{N^*(\infty)} \qquad (4)$$

et

$$N^*(t) = \frac{1}{\tau(t)} - \frac{1}{\tau_0} \qquad (5),$$

où $\tau_0$ est la durée de vie des porteurs avant exposition et $N^*(\infty)$ est la valeur limite (et maximale) de $N^*(t)$, c'est-à-dire la concentration en complexes bore-oxygène lorsque tous les complexes ont été activés. En fait, $N_{rel}^*$ est une concentration relative des complexes bore-oxygène.

Les mesures de durée de vie sont, de préférence, réalisées par la technique IC-QssPC, la technique IC-PCD ou la technique μW-PCD. Ces techniques étant classiques, elles ne seront pas détaillées dans cette demande.

De préférence, le lingot de silicium est soumis à une lumière blanche d'intensité comprise entre 1 mW/cm² et 10 W/cm² et la température du lingot est comprise entre 0 °C et 100 °C. La source de lumière blanche est, par exemple, une lampe halogène ou une lampe au xénon.

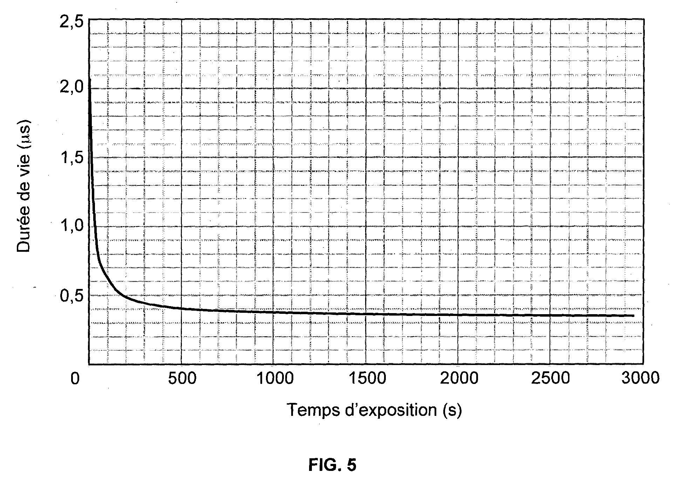

La figure 5 est un relevé de la durée de vie $\tau$ des porteurs en fonction du temps d'exposition à la lumière blanche, en bas du lingot de silicium. Dans cet exemple, la température du silicium est de 52,3 °C et l'intensité lumineuse est de l'ordre de 0,05 W.cm⁻².

A partir de ce relevé, il est possible de calculer la concentration relative $N_{rel}^*$ des complexes bore-oxygène, et de remonter à la concentration $q_0$ (relations 1 à 5). La valeur de $q_0$ obtenue avec cette technique est de l'ordre de $6,3.10^{16}$ cm⁻³.

Le suivi sous éclairement de la durée de vie $\tau$ des porteurs peut être continu, comme dans le cas de la figure 5, ou discontinu, à condition que la plaquette ou le lingot soit dans l'obscurité pendant la période d'arrêt entre deux périodes de mesure de la durée de vie.

Dans une variante de mise en oeuvre, la concentration $N_{rel}^*$ est déterminée à l'aide d'un relevé de la longueur de diffusion $L_D$ des porteurs de charge, qui dépend directement de leur durée de vie :

$$\tau(t) = \frac{\mu}{L_D^2(t)}.$$

Les valeurs de $L_D$ peuvent être obtenues à partir de cartographies de photocourant (LBIC, « Light Beam Induced Current » en anglais). Le terme μ est la mobilité des porteurs dans l'échantillon. Sa connaissance n'est toutefois pas requise, car il se simplifie dans l'équation (4).

La technique associée à l'activation des complexes bore-oxygène, via des mesures de durée de vie ou de longueur de diffusion, est simple à mettre en oeuvre. En effet, elle ne nécessite pas de préparation d'échantillon, contrairement à la mesure par effet Hall. En outre, elle est sans contact et peut donc être appliquée directement sur une zone de type p du lingot.

De préférence, le lingot est exempt d'impuretés autres que les dopants (donneurs et accepteurs) et l'oxygène. En particulier, il est avantageux que le lingot soit exempt de fer.

Les techniques de détermination de la concentration $q_0$ décrites ci-dessus (étape F2) pourront être utilisées avec l'une quelconque des techniques de détermination de la hauteur $h_{eq}$ (F1). On pourra également procéder à l'étape F2 avant l'étape F1.

L'étape F3 de la figure 2 correspond au calcul des concentrations en bore et phosphore en bas du lingot à partir de la hauteur $h_{eq}$ déterminée à l'étape F1 et de la concentration $q_0$ mesurée à l'étape F2. Ce calcul s'appuie sur la loi de Scheil-Gulliver qui décrit la variation des concentrations en bore et phosphore dans le lingot de la manière suivante :

$$\left[B\right]_h = \left[B\right]_0 (1-h)^{k_B-1} \quad (6),$$

$$\left[P\right]_h = \left[P\right]_0 (1-h)^{k_P-1} \quad (7).$$

$[B]_h$ et $[P]_h$ sont les concentrations en bore et en phosphore à une hauteur h quelconque du lingot. $[B]_0$ et $[P]_0$ désignent les concentrations en bore et en phosphore en bas du lingot. Enfin, $k_B$ et $k_P$ sont respectivement les coefficients de partage du bore et du phosphore, appelés également coefficients de ségrégation ($k_B$, $k_P < 1$).

A la hauteur $h_{eq}$, le silicium est parfaitement compensé. On en déduit la relation suivante :

$$\left[B\right]_{h_{eq}} = \left[P\right]_{h_{eq}} \quad (8).$$

En remplaçant $[B]_{h_{eq}}$ et $[P]_{h_{eq}}$ par les expressions (6) et (7), la relation (8) devient :

$$\left[B\right]_0 (1-h_{eq})^{k_B-1} = \left[P\right]_0 (1-h_{eq})^{k_P-1} \quad (9).$$

Par ailleurs, les concentrations en bore $[B]_0$ et en phosphore $[P]_0$ en bas du lingot sont liées par la relation suivante :

$$\left[B\right]_0 - \left[P\right]_0 = q_0 \quad (10).$$

La relation (10) est valable dans le cas d'un type p en bas de lingot. Dans le cas d'un type n, obtenu avec du phosphore et du gallium par exemple, on prendra la relation opposée :

$$\left[P\right]_0 - \left[B\right]_0 = q_0 \quad (10').$$

En résolvant le système d'équations (9) et (10), on obtient l'expression des concentrations $[B]_0$ et $[P]_0$ en fonction de $h_{eq}$ et $q_0$ :

$$\left[B\right]_0 = \frac{q_0 (1-h_{eq})^{k_P-1}}{(1-h_{eq})^{k_P-1} - (1-h_{eq})^{k_B-1}} \quad (11),$$

$$\left[P\right]_0 = \left[B\right]_0 - q_0 \quad (12).$$

Les relations (11) et (12) permettent donc de calculer les concentrations en bore et en phosphore en bas du lingot, à partir de la hauteur $h_{eq}$ de la transition p-n et de la concentration $q_0$ en porteurs de charge. On peut ensuite remonter aux concentrations en dopants dans l'ensemble du lingot, à l'aide des relations (7) et (8).

En outre, il est possible de calculer directement les concentrations initiales en bore et en phosphore dans la charge de silicium ayant servi au tirage du lingot. Ces concentrations, notées $[B]_C$ et $[P]_C$, se déduisent des relations (11) et (12) de la manière suivante :

$$[B]_C = \frac{[B]_0}{k_B} = \frac{1}{k_B} \frac{q_0(1-h_{eq})^{k_P-1}}{(1-h_{eq})^{k_P-1} - (1-h_{eq})^{k_B-1}} \qquad (13),$$

$$[P]_C = \frac{[P]_0}{k_P} = \frac{k_B[B]_C - q_0}{k_P} \qquad (14).$$

Dans le cas du type n en bas de lingot, on remplacera $q_0$ par $-q_0$ dans les relations (11) à (14), conformément à la relation (10').

Les expressions (11) à (14) peuvent être généralisées à tous les dopants accepteurs et donneurs. Pour déterminer la concentration en dopants accepteurs $N_A$ et la concentration en dopants donneurs $N_D$, on remplacera simplement les coefficients de partage du bore et du phosphore, $k_B$ et $k_P$, par les coefficients des dopants accepteurs et donneurs utilisés, $k_A$ et $k_D$.

Le tableau 1 ci-dessous regroupe les valeurs de $h_{eq}$ et de $q_0$ obtenues précédemment. Les concentrations en bore et en phosphore en bas de lingot, $[B]_0$ et $[P]_0$, ont été calculées à l'aide des relations (11) et (12), pour deux des trois techniques de détermination de $q_0$ envisagées ci-dessus : l'effet Hall et le suivi de la cinétique d'activation des complexes bore-oxygène (désigné « LID » dans le tableau). A titre de comparaison, le tableau 1 indique les valeurs attendues des concentrations $[B]_0$ et $[P]_0$ (échantillon de référence), ainsi que les valeurs obtenues par la méthode de l'art antérieur (résistivité).

**Tableau 1**

|  | $h_{eq}$ (%) | $q_0$ (cm$^{-3}$) | $[B]_0$ (cm$^{-3}$) | $[P]_0$ (cm$^{-3}$) |
|---|---|---|---|---|
| **Valeurs attendues** |  |  | $2,6.10^{17}$ | $1,2.10^{17}$ |
| **Effet Hall** | 76 | $9,3.10^{16}$ | $1,9.10^{17}$ | $1,0.10^{17}$ |
| **LID** | 76 | $6,3.10^{16}$ | $1,3.10^{17}$ | $7,0.10^{16}$ |
| **Résistivité** | 76 | $4,9.10^{16}$ | $1,0.10^{17}$ | $5,4.10^{16}$ |

On constate que les valeurs des concentrations en dopants obtenues à l'aide du procédé de la figure 2 (Effet Hall, LID) sont plus proches des valeurs attendues que celles obtenues par la méthode de l'art antérieur. Ainsi, en s'affranchissant de la résistivité lors du calcul de l'étape F3, on obtient des valeurs précises de la concentration en bore et de la concentration en phosphore dans le lingot de silicium compensé.

Le procédé de détermination des teneurs en dopants a été décrit en relation avec une mesure de la concentration en porteurs de charge en bas du lingot ($q_0$). Toutefois, cette concentration pourra être déterminée dans une zone quelconque du lingot (q). Les équations (6) à (14) seront alors modifiées en conséquence.

Le procédé a été décrit avec un seul type de dopants accepteurs, le bore, et un seul type de dopants donneurs, le phosphore. On peut toutefois utilisé plusieurs sortes de dopants accepteurs et plusieurs sortes de dopants donneurs. On obtiendra alors un système à n équations (n étant le nombre d'inconnues, c'est-à-dire le nombre de dopants différents). Pour le résoudre, on effectuera n-1 mesures de la concentration en porteurs de charge q, à des hauteurs différentes du lingot, et 1 mesure de la hauteur $h_{eq}$ à laquelle on a l'équilibre des concentrations en dopants (somme des concentrations en dopants de type p = somme des concentrations en dopants de type n).

**Revendications**

**1.** Procédé de détermination des concentrations en impuretés dopantes ($N_A$, $N_D$) dans un échantillon de silicium, comprenant les étapes suivantes :

- prévoir un lingot de silicium comportant des impuretés dopantes de type donneur, des atomes de bore et des atomes d'oxygène ;
- déterminer (F1) la position ($h_{eq}$) d'une première zone du lingot, dans laquelle s'effectue une transition entre un premier type de conductivité et un second type de conductivité opposé ;
- mesurer (F2) la concentration (q) en porteurs de charge libres dans une seconde zone du lingot, de type p et distincte de la première zone, en suivant l'évolution sous éclairement de la durée de vie ($\tau$) des porteurs de charge ; et
- déterminer (F3) les concentrations en impuretés dopantes dans l'échantillon à partir de la position ($h_{eq}$) de la première zone et de la concentration en porteurs de charge libres (q) dans la seconde zone du lingot.

2. Procédé selon la revendication 1, comprenant une étape d'activation de complexes bore-oxygène par illumination du lingot de silicium.

3. Procédé de détermination des concentrations en impuretés dopantes ($N_A$, $N_D$) dans un échantillon de silicium, comprenant les étapes suivantes :

- prévoir un lingot de silicium comportant des impuretés dopantes de type donneur et des impuretés dopantes de type accepteur ;
- déterminer (F1) la position ($h_{eq}$) d'une première zone du lingot, dans laquelle s'effectue une transition entre un premier type de conductivité et un second type de conductivité opposé ;
- mesurer (F2) la concentration (q) en porteurs de charge libres dans une seconde zone du lingot, distincte de la première zone, par effet Hall ou par spectroscopie infrarouge à transformée de Fourrier ; et
- déterminer (F3) les concentrations en impuretés dopantes ($N_A$, $N_D$) dans l'échantillon à partir de la position ($h_{eq}$) de la première zone et de la concentration en porteurs de charge libres (q) dans la seconde zone du lingot.

4. Procédé selon l'une quelconque des revendications 1 à 3, dans lequel la seconde zone est une extrémité du lingot représentative d'un début de solidification.

5. Procédé selon la revendication 4, dans lequel la concentration en impuretés dopantes de type accepteur $N_A$ et la concentration en impuretés dopantes de type donneur $N_D$ à l'extrémité du lingot sont déterminées à l'aide des relations suivantes :

$$N_A = \frac{q_0(1-h_{eq})^{k_D-1}}{(1-h_{eq})^{k_D-1} - (1-h_{eq})^{k_A-1}} \qquad \text{et} \qquad N_D = N_A - q_0,$$

dans lesquelles $q_0$ est la concentration en porteurs de charge libres à l'extrémité du lingot, $h_{eq}$ est la position de la première zone du lingot, $k_D$ et $k_A$ sont respectivement des coefficients de partage des impuretés de type donneur et accepteur.

6. Procédé selon la revendication 4, dans lequel la concentration en impuretés dopantes de type accepteur $N_A$ et la concentration en impuretés dopantes de type donneur $N_D$ dans une charge de silicium ayant servi à la formation du lingot sont déterminées à l'aide des relations suivantes :

$$N_A = \frac{1}{k_A} \cdot \frac{q_0(1-h_{eq})^{k_D-1}}{(1-h_{eq})^{k_D-1} - (1-h_{eq})^{k_A-1}} \qquad \text{et} \qquad k_D N_D = k_A N_A - q_0,$$

dans lesquelles $q_0$ est la concentration en porteurs de charge libres à l'extrémité du lingot, $h_{eq}$ est la position de la première zone du lingot, $k_D$ et $k_A$ sont respectivement des coefficients de partage des impuretés de type donneur et accepteur.

7. Procédé selon l'une quelconque des revendications 1 à 6, dans lequel la position ($h_{eq}$) de la première zone du lingot est obtenue à l'aide des étapes suivantes :

- soumettre des portions (P1, P2, P3) du lingot à un traitement chimique à base d'acide fluorhydrique, d'acide nitrique, et d'acide acétique ou phosphorique, permettant de révéler des défauts sur l'une des portions correspondant à la transition entre le premier type de conductivité et le second type de conductivité ;
- déterminer la position dans le lingot de la portion (P2) présentant les défauts.

**Patentansprüche**

1. Verfahren zur Bestimmung der Konzentrationen an Dotierungsstörstellen ($N_A$, $N_D$) in einer Siliziumprobe, umfassend die folgenden Schritte:

   - Vorsehen eines Siliziumblocks, der Dotierungsstörstellen vom Donator-Typ, Boratome und Sauerstoffatome umfasst;
   - Bestimmen (F1) der Position ($h_{eq}$) eines ersten Bereichs des Blocks, in dem ein Übergang zwischen einem ersten Leitfähigkeitstyp und einem entgegengesetzten zweiten Leitfähigkeitstyp stattfindet;
   - Messen (F2) der Konzentration (q) an freien Ladungsträgern in einem zweiten Bereich des Blocks, der vom p-Typ und von dem ersten Bereich verschieden ist, unter Verfolgen der Entwicklung der Lebensdauer ($\tau$) der Ladungsträger unter Beleuchtung; und
   - Bestimmen (F3) der Konzentrationen an Dotierungsstörstellen in der Probe anhand der Position ($h_{eq}$) des ersten Bereichs und der Konzentration an freien Ladungsträgern (q) in dem zweiten Bereich des Blocks.

2. Verfahren nach Anspruch 1, umfassend einen Schritt zur Aktivierung von Bor-Sauerstoff-Komplexen durch Beleuchten des Siliziumblocks.

3. Verfahren zur Bestimmung der Konzentrationen an Dotierungsstörstellen ($N_A$, $N_D$) in einer Siliziumprobe, umfassend die folgenden Schritte:

   - Vorsehen eines Siliziumblocks, der Dotierungsstörstellen vom Donator-Typ und Dotierungsstörstellen vom Akzeptor-Typ umfasst;
   - Bestimmen (F1) der Position ($h_{eq}$) eines ersten Bereichs des Blocks, in dem ein Übergang zwischen einem ersten Leitfähigkeitstyp und einem entgegengesetzten zweiten Leitfähigkeitstyp stattfindet;
   - Messen (F2) der Konzentration (q) an freien Ladungsträgern in einem von dem ersten Bereich verschiedenen zweiten Bereich des Blocks durch Hall-Effekt oder durch Fourier-Transform-Infrarotspektroskopie; und
   - Bestimmen (F3) der Konzentrationen an Dotierungsstörstellen ($N_A$, $N_D$) in der Probe anhand der Position ($h_{eq}$) des ersten Bereichs und der Konzentration an freien Ladungsträgern (q) in dem zweiten Bereich des Blocks.

4. Verfahren nach einem der Ansprüche 1 bis 3, bei dem der zweite Bereich ein Ende des Blocks ist, das für einen Erstarrungsbeginn repräsentativ ist.

5. Verfahren nach Anspruch 4, bei dem die Konzentration an Dotierungsstörstellen vom Akzeptor-Typ $N_A$ und die Konzentration an Dotierungsstörstellen vom Donator-Typ $N_D$ an dem Ende des Blocks mit Hilfe der folgenden Beziehungen bestimmt werden:

$$N_A = \frac{q_0(1-h_{eq})^{k_D-1}}{(1-h_{eq})^{k_D-1} - (1-h_{eq})^{k_A-1}} \quad \text{und} \quad N_D = N_A - q_0,$$

worin $q_0$ die Konzentration an freien Ladungsträgern am Ende des Blocks ist, $h_{eq}$ die Position des ersten Bereichs des Blocks ist, $k_D$ und $k_A$ Verteilungskoeffizienten der Störstellen vom Donator- bzw. Akzeptor-Typ sind.

6. Verfahren nach Anspruch 4, bei dem die Konzentration an Dotierungsstörstellen vom Akzeptor-Typ $N_A$ und die Konzentration an Dotierungsstörstellen vom Donator-Typ $N_D$ in einer Siliziumladung, die der Bildung des Blocks diente, mit Hilfe der folgenden Beziehungen bestimmt werden:

$$N_A = \frac{1}{k_A} \cdot \frac{q_0(1-h_{eq})^{k_D-1}}{(1-h_{eq})^{k_D-1}-(1-h_{eq})^{k_A-1}} \quad \text{und} \qquad k_D N_D = k_A N_A - q_0,$$

worin $q_0$ die Konzentration an freien Ladungsträgern am Ende des Blocks ist, $h_{eq}$ die Position des ersten Bereichs des Blocks ist, $k_D$ und $k_A$ Verteilungskoeffizienten der Störstellen vom Donator- bzw. Akzeptor-Typ sind.

7. Verfahren nach einem der Ansprüche 1 bis 6, bei dem die Position ($h_{eq}$) des ersten Bereichs des Blocks mit Hilfe der folgenden Schritte erhalten wird:

   - Unterziehen von Abschnitten (P1, P2, P3) des Blocks einer chemischen Behandlung auf der Basis von Fluorwasserstoffsäure, Salpetersäure und Essig- oder Phosphorsäure, die ermöglicht, Defekte an einem der Abschnitte, welcher dem Übergang zwischen dem ersten Leitfähigkeitstyp und dem zweiten Leitfähigkeitstyp entspricht, aufzudecken;
   - Bestimmen der Position, in dem Block, des Abschnittes (P2), der die Defekte aufweist.

**Claims**

1. A method for determining concentrations of dopant impurities ($N_A$, $N_D$) in a silicon sample comprising the following steps:

   - providing a silicon ingot comprising dopant impurities of donor type, boron atoms and oxygen atoms;
   - determining (F1) the position ($h_{eq}$) of a first area of the ingot in which a transition takes place between a first conductivity type and an opposite second conductivity type;
   - measuring (F2) the free charge carrier concentration (q) in a second area of the ingot, of p-type and different from the first area, by monitoring the variation under illumination of the lifetime ($\tau$) of the charge carriers; and
   - determining (F3) the concentrations of dopant impurities in the sample from the position ($h_{eq}$) of the first area and the free charge carrier concentration (q) in the second area of the ingot

2. The method according to claim 1, comprising an activation step of boron-oxygen complexes by illumination of the silicon ingot.

3. A method for determining concentrations of dopant impurities ($N_A$, $N_D$) in a silicon sample comprising the following steps:

   - providing a silicon ingot comprising dopant impurities of donor type and dopant impurities of acceptor type;
   - determining (F1) the position ($h_{eq}$) of a first area of the ingot in which a transition takes place between a first conductivity type and an opposite second conductivity type;
   - measuring (F2) the free charge carrier concentration (q) in a second area of the ingot, different from the first area, by Hall effect or by Fourier transform infrared spectroscopy; and
   - determining (F3) the concentrations of dopant impurities ($N_A$, $N_D$) in the sample from the position ($h_{eq}$) of the first area and the free charge carrier concentration (q) in the second area of the ingot.

4. The method according to any one of claims 1 to 3, wherein the second area is an end of the ingot representative of a beginning of solidification.

5. The method according to claim 4, wherein the concentration of acceptor-type dopant impurities $N_A$ and the concentration of donor-type dopant impurities $N_D$ at the end of the ingot are determined by means of the following relations:

$$N_A = \frac{q_0(1-h_{eq})^{k_D-1}}{(1-h_{eq})^{k_D-1}-(1-h_{eq})^{k_A-1}} \qquad \text{and} \qquad N_D = N_A - q_0,$$

wherein $q_0$ is the free charge carrier concentration at the end of the ingot, $h_{eq}$ is the position of the first area of the ingot, and $k_D$ and $k_A$ are respectively sharing coefficients of the donor and acceptor impurities.

6. The method according to claim 4, wherein the concentration of acceptor-type dopant impurities $N_A$ and the concentration of donor-type dopant impurities $N_D$ in a silicon feedstock used for formation of the ingot are determined by means of the following relations:

$$N_A = \frac{1}{k_A} \cdot \frac{q_0(1-h_{eq})^{k_D-1}}{(1-h_{eq})^{k_D-1} - (1-h_{eq})^{k_A-1}} \quad \text{and} \quad k_D N_D = k_A N_A - q_0,$$

wherein $q_0$ is the free charge carrier concentration at the end of the ingot, $h_{eq}$ is the position of the first area of the ingot, and $k_D$ and $k_A$ are respectively sharing coefficients of the donor and acceptor impurities.

7. The method according to any one of claims 1 to 6, wherein the position ($h_{eq}$) of the first area of the ingot is obtained by means of the following steps:

   - subjecting portions (P1, P2, P3) of the ingot to chemical treatment based on hydrofluoric acid, nitric acid, and acetic or phosphoric acid, enabling defects to be revealed on one of the portions corresponding to the transition between the first conductivity type and the second conductivity type;
   - determining the position in the ingot of the portion (P2) presenting the defects.

Concentrations
en dopants

$[P]$

$[B]$

$[B]_{h_{eq}} = [P]_{h_{eq}}$

$h_{eq}$

Hauteur h
dans le lingot

type p          type n

**FIG. 1 (Art antérieur)**

Déterminer la hauteur $h_{eq}$ pour laquelle le lingot
change de type de conductivité — F1

Mesurer la concentration $q_0$ en porteurs de
charge libres en bas de lingot — F2

Calculer les concentrations en dopants en bas de
lingot $[B]_0$ et $[P]_0$ à partir de la hauteur $h_{eq}$ et de la
concentration $q_0$ en porteurs de charge libres — F3

**FIG. 2**

**FIG. 3**

**FIG. 4**

FIG. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CA 2673621

**Littérature non-brevet citée dans la description**

- **B. DREVET et al.** Segragation and crystallization of purified metallurgical grade silicon : Influence of process parameters on yield and solar cell efficiency. *25th European PV Solar Energy Conference and Exhibitation, Valencia,* 2010
- **BIANCA LIM ; MARTIN WOLF ; JAN SCHMIDT.** Carrier mobilities in multicrystalline silicon wafers made from UMG-Si. *Phys. Status Solidi C,* 2011, vol. 8, 835-838
- **F.E. ROUGIEUX et al.** Electron and hole mobility reduction and Hall factor in phosphorus-compensated p-type silicon. *Journal of Applied Physics,* 2010, vol. 108, 013706
- **J. GEILKER et al.** Doping concentration and mobility in compensated material : comparison of different determination methods. *25th European PV Solar Energy Conference and Exhibition, Valencia,* 2010
- **D. HINKEN et al.** Determination of the base dopant concentration of large area crystalline silicon solar cells. *25th European PV Solar Energy Conference and Exhibition, Valencia,* 2010
- **D.W. PALMER et al.** Kinetics of the electronically stimulated formation of a boron-oxygen complex in cristalline silicon. *Physical Review B,* 2007, vol. 76, 035210